# EUROPEAN PATENT APPLICATION

(11) **EP 0 962 990 A2**
(43) Date of publication of application: **08.12.1999**
(21) Application number: 99109370.9
(22) Date of filing: 01.06.1999
(51) Int. Cl.: H01L 31/18, H01L 31/072, H01L 27/142

(54) **Method of fabricating a solar cell**

(30) Priority: 05.06.1998 JP 15758498
(71) Applicant: Matsushita Battery Industrial Co., Ltd., Moriguchi-shi, Osaka 570-8511 (JP)
(72) Inventor: Hanafusa, Akira, Hirakata-shi, Osaka 573-1167 (JP); Kumazawa, Seiji, Kadoma-shi, Osaka 571-0029 (JP); Murozono, Mikio, Hirakata-shi, Osaka 573-0075 (JP)
(74) Representative: Jung, Elisabeth, Dr.

(57) **Abstract**

The present invention provides of a method of fabricating, with a high degree of production efficiency, a high photoelectric efficiency solar cell having a large inter-cell separation resistance. The solar cell fabrication process of the invention comprises the steps of: forming a transparent conductive film (11) on a transparent insulating substrate (10), and forming a cadmium sulfide film (2) on the transparent conductive film (11), and dividing together the transparent conductive film (11) and the cadmium sulfide film (2) into portions for respective unit cells in the same prescribed pattern by radiating a laser beam onto the cadmium sulfide film (2) in the prescribed pattern and thereby removing simultaneously the cadmium sulfide film (2) and the transparent conductive film (11) at portions thereof lying below the irradiated portions.

## Description

### BACKGROUND OF THE INVENTION

The present invention relates to a method of fabricating a II-VI compound semiconductor solar cell, in particular, a CdS/CdTe solar cell.

A solar cell sub-module is fabricated by forming a plurality of unit cells on a transparent insulating substrate, such as a glass substrate, and electrically connecting the unit cells. In a commonly practiced method for the fabrication of such a solar cell sub-module, first a transparent conductive film is formed on the substrate, and the transparent conductive film is then divided into a prescribed pattern to form transparent electrodes for the respective unit cells. Next, a semiconductor thin film is formed on the above structure, thus forming the plurality of cells.

As an example, Japanese Laid-Open Patent Publication No. Sho 57-12568 and U.S.Patent No.4,292,092 propose a method in which the transparent conductive film is partially removed using a laser beam to divide the film into the transparent electrodes for the respective unit cells and, after forming a semiconductor film on this structure, portions of the semiconductor thin film parallel and adjacent to the removed portions of the transparent conductive film are removed in a prescribed pattern, thus dividing the semiconductor film to form a plurality of unit cells.

Usually, a film of indium oxide (In₂O₃) or a film of tin dioxide (SnO₂) doped with fluorine to confer electrical conductivity is used as the transparent conductive film. When the semiconductor film is formed on this transparent conductive film, indium or fluorine is incorporated into the semiconductor film. The effect of this phenomenon on the solar cell characteristics varies depending on the solar cell structure. For example, in an amorphous silicon solar cell, it is usual to dispose a p-type amorphous silicon film on the side contacting the transparent electrode; if indium or fluorine is incorporated into this p-type film, only negligible change occurs in the film property, which presents no serious problems.

However, in the case of a solar cell constructed by forming a cadmium sulfide film (CdS film) and a cadmium telluride film (CdTe film) on the transparent electrode structure divided as described above, when the CdS film is formed, the indium or the fluorine in the transparent electrode structure is diffused as a donor into the CdS film, increasing the donor density in the CdS film and reducing the electrical resistance. As a result, if the separation resistance between the transparent electrodes is sufficiently large at the time the transparent conductive film is divided into the transparent electrodes, after the formation of the CdS film, the separation resistance between the transparent electrodes becomes extremely small because the electrical resistance of the CdS film located over the removed portions of the transparent conductive film is reduced. This has been considered a major problem to be overcome in increasing the photo-electric conversion efficiency of the solar cell sub-module, since the leakage current between the unit cells increases when the unit cells are fabricated into series connected solar cells.

Furthermore, when forming the transparent electrodes by dividing the transparent conductive film, the SnO₂ or In₂O₃ tends to coagulate after being vaporized by the heat of the laser beam, the coagulated substance often falling in a powder form onto the transparent electrodes structure and adhering to it. Since this could lead to the creation of pinholes when the CdS film was formed thereon, a cleaning with pure water, etc. has had to be done before the forming of the CdS film. That is, though a elaborate cleaning was done before the formation of the transparent conductive film, similar cleaning has had to be done once again; this has hampered the simplification of the fabrication process and posed a major barrier to reducing the fabrication cost.

### BRIEF SUMMARY OF THE INVENTION

It is an object of the present invention to provide a method of fabricating a high photo-electric conversion efficiency, low cost CdS/CdTe solar cell by resolving the above-described problems of the prior art.

The solar cell fabrication method of the present invention comprises the steps of: forming a transparent conductive film on a transparent insulating substrate: forming a CdS film on the transparent conductive film; and dividing the transparent conductive film and the CdS film into portions for respective unit cells by radiating a laser beam in a prescribed pattern onto the CdS film and thereby removing simultaneously the CdS film at portions thereof irradiated with the laser beam and the transparent conductive film at portions thereof lying below the irradiated portions.

The above described method of the present invention thus provides a simplified fabrication process by which a plurality of unit cells with a sufficiently large inter-cell separation resistance can be formed on the transparent insulating substrate, and by connecting these unit cells in series, a high photo-electric conversion efficiency, low cost solar cell with reduced inter-cell leakage current can be constructed.

While the novel features of the invention are set forth particularly in the appended claims, the invention, both as to organization and content, will be better understood and appreciated, along with other objects and features thereof, from the following detailed description taken in conjunction with the drawings.

### BRIEF DESCRIPTION OF THE SEVERAL VIEWS OH THE DRAWING

Fig.1 is a schematic cross sectional view showing a fabrication process sequence for a solar cell in a EXAMPLE of the present invention.
Fig.2 is a schematic cross sectional view of a solar cell in a COMPARATIVE EXAMPLE.

### DETAILED DESCRIPTION OF THE INVENTION

The solar cell fabrication method according to the present invention is characterized in that after forming the transparent conductive film on the transparent insulating substrate, the CdS film is formed, followed by the radiation of a laser beam and thus causing the irradiated portions of the CdS film and the underlying portions of the transparent conductive film to be evaporated by the absorbed heat of the laser beam radiation and removed into the same prescribed pattern.

According to the present invention, as a method of forming the CdS film on the transparent conductive film, it is preferable to employ, for example, a method of thermally decomposing an organic compound containing a cadmium-sulfur bond, as disclosed in Japanese Laid-Open Patent Publication No. Hei 8-88382 or U.S.Patent No.5,714,391. The method of forming a CdS film by thermally decomposing the above-mentioned organic compound includes following methods in the concrete.

The first method is, for example, a method of applying the organic solvent solution of above-mentioned organic compound to the transparent conductive film formed on the transparent insulating substrate so as to form an applied film, heating the insulating transparent substrate and thermally decomposing above-mentioned organic compound in above-mentioned applied film, as disclosed in Japanese Laid-Open Patent Publication No. Hei 9-74213.

The second method is, for example, a method of pulverizing an organic solvent solution of above-mentioned organic compound into fine particles, and thereafter, vaporizing the organic solvent by heating the fine particles, vaporizing the organic compound into gaseous bodies by heating further, thermally decomposing the obtained gaseous organic compound by contacting the obtained gaseous organic compound at the heated surface of the transparent conductive film formed on the heated transparent insulating substrate, as disclosed in Japanese Laid-Open Patent Publication No. Hei 11-87748.

The third method is a method of applying an organic solvent solution of above-mentioned organic compound to a source substrate so as to form an applied film, disposing above-mentioned applied film and a transparent conductive film formed on the a transparent insulating substrate adjacently so as to be parallel to and face each other, heating above-mentioned source substrate so as to evaporate above-mentioned organic compound in above-mentioned applied film and thermally decomposing above-mentioned evaporated organic compound which has reached the surface of above-mentioned transparent conductive film formed on above-mentioned transparent insulating substrate heated to a temperature higher than that of the source substrate, as disclosed in Japanese Laid-Open Patent Publication No. Hei 10-4206.

According to the present invention, it is also possible, as a method of forming a CdS film on above-mentioned transparent conductive film, to employ other methods such as liquid phase deposition, close spaced sublimation, evaporation and sputtering, without utilizing above-mentioned method of thermally decomposing above-mentioned organic compound.

Further, as a preferable method of fabricating a solar cell in accordance with the present invention, it is possible to employ a fabricating method comprising the steps of forming a transparent conductive film on a transparent insulating substrate, further forming a CdS film on the transparent conductive film, dividing the transparent conductive film and the CdS film into portions for respective unit cells, forming a CdTe film on the CdS film, dividing the CdTe film into portions for respective unit cells, forming a collector film on each of the divided CdTe films, electrically connecting the collector films and the divided CdS films of adjacent unit cells and forming a positive terminal or a negative terminal on unit cells at both ends of a group of unit cells formed on the substrate, in which above-mentioned step of dividing above-mentioned transparent conductive film and above-mentioned CdS film into portions for respective unit cells is the step of radiating a laser beam in a prescribed pattern onto above-mentioned CdS film and removing simultaneously the CdS film at portions thereof irradiated with above-mentioned laser beam and the transparent conductive film at portions thereof lying below the irradiated portions.

Also, according to the present invention, it is preferable, as a method of forming the CdTe film on the CdS film, to employ, for example, a method of placing a source material containing a CdTe as its main component on a source substrate, disposing the source material and a CdS film formed on a transparent conductive film on a transparent insulating substrate adjacently so as to be parallel to and face each other, heating above-mentioned source substrate and thus sublimating above-mentioned source material and depositing a CdTe film on above-mentioned CdS film heated to a temperature lower than that of the source substrate, as disclosed in U.S.Patent No.5,304,499.

Compared with the prior art, the present invention offers excellent advantages as described below.

First, since the transparent conductive film and CdS film formed on the transparent insulating substrate are simultaneously scribed in the same pattern, the chance is eliminated for the low resistance portions of CdS, created by the high concentration diffusion of fluorine or indium, to remain on the portions of the transparent insulating substrate where the transparent conductive film was removed. By dividing the transparent conductive film and the CdS film into portions for respective unit cells in this manner, a reliable electrical insulation can be provided between the unit cells. By forming the CdTe film thereon in a prescribed pattern, the plurality of unit cells with a large inter-cell separation resistance can be constructed.

On the other hand, in the case of the prior art of fabricating a solar cell, after dividing the transparent conductive film into a prescribed pattern using a laser beam, the CdS film is formed, and then the CdTe film is formed thereon in a prescribed pattern to form the plurality of unit cells. In this case, the solar cell is fabricated based on the thought that since the intrinsic electric resistance of the CdS film is inherently high, the inter-cell insulation can be provided without dividing the CdS film into portions for unit cells. In reality, however, the reduction in the resistance of the CdS film is unavoidable for the reason described earlier, and the low resistance portions of CdS remain at the portions where the transparent conductive film was removed when dividing. This has caused the problem of reduced inter-cell separation resistance. If, to avoid this problem, it is attempted to divide the CdS film formed after dividing the transparent conductive film, in exactly the same pattern as that for the transparent conductive film, it is virtually impossible to divide the CdS film with good precision, and thus it has not been possible to solve the above problem.

As described, according to the present invention, the separation resistance between the unit cells formed on the transparent insulating substrate can be increased, and by connecting these unit cells in series, a high photo-electric conversion efficiency solar cell with reduced inter-cell leakage current can be provided.

Second, by simultaneously scribing the transparent conductive film and CdS film by the laser beam, almost no scribing debris deposits on the CdS film and, if it does deposit, it does not adhere to the CdS film. The reason for this is not clear, but it is presumably because the SnO₂ or In₂O₃ vaporized by the laser radiation interacts with CdS in the gaseous phase. Accordingly, unlike the prior art in which only the transparent conductive film is scribed by the laser beam, the present invention obviates special removal procedures such as removing the scribing debris by cleaning with pure water, etc. This simplifies the fabrication process and achieves the construction of a low cost solar cell. The present invention will be described below in further detail by way of EXAMPLE.

### EXAMPLE 1

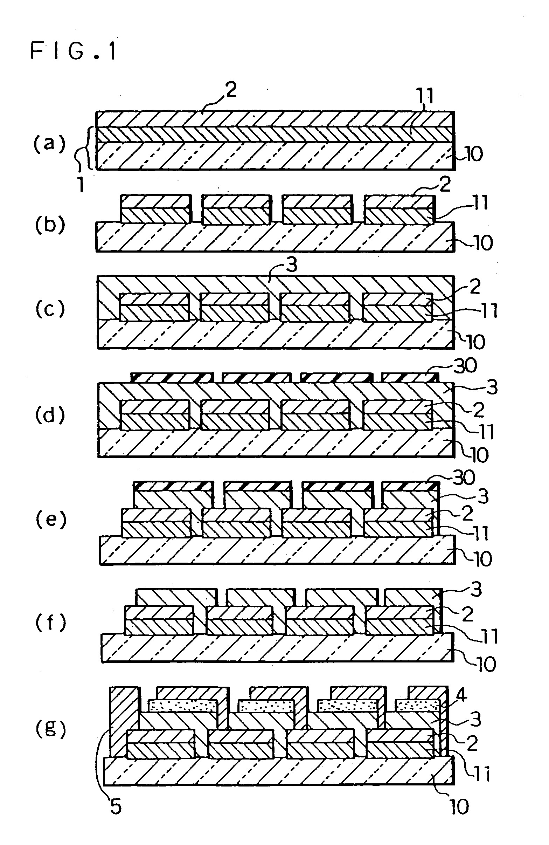

A solution prepared by adding hydrofluoric acid to a aqueous solution of tin chloride was sprayed over a 35 cm by 35 cm glass substrate 10 (Corning #1737) shown in Fig.1(a), and the resulting structure was heated at 550°C for about 20 minutes to form an SnO₂ film 11 to a thickness of about 600 nm, thus building a thin film forming substrate 1. Next, a solution prepared by dissolving cadmium isopropyl xanthate, an organic compound containing a metal-sulfur bond, in 1-methyl-2-pyrrolidone was applied over the SnO₂ film 11 on the thin film forming substrate 1, and was dried at 110°C to let the solvent evaporate. After that, by heating at 450°C for 3 minutes in the air atmosphere, the organic compound was heat-decomposed, thereby forming a CdS film 2 about 70 nm in thickness.

Next, a laser beam was radiated using a Q-switched YAG laser with a wavelength of 1.06 µm, a frequency of 2 kHz and a power of 2 W with a moving speed of 100 mm per second and a lens focal length of 25 mm, and the irradiated portions of the CdS film 2 and the SnO₂ film 11 at portions lying below the irradiated portions were removed by evaporation, thus scribing both of the films 2 and 11 simultaneously with a pattern dividing the both films 2 and 11 into sections equivalent to 42 unit cells. In this way, the CdS film 2 and the SnO₂ film 11 were divided into portions for respective cells in the sane pattern, as shown in Fig.1(b).

Next, using close spaced sublimation method, a CdTe film 3 with a thickness of about 6 µm was formed as shown in Fig.1(c). For the CdTe film forming, a CdTe powder with a fineness of 5N was spread all over a 35 cm by 35 cm glass plate (Corning #1737) as a source substrate to form a particle layer thereon, and the CdTe film was formed in an argon atmosphere by placing the particle layer facing the CdS thin film 2 side of the thin film forming substrate 1 with a spacer interposed there between. The film forming conditions were such that the thin film forming substrate 1 was held at 600°C and the source substrate at 630°C and the thin film forming substrate 1 and the source substrate were separated by the distance of 2 mm. The film forming time was two minutes. After the forming of the CdTe film, the structure was immersed in a saturated methanol solution of cadmium chloride and, after drying, was heat treated at 400°C for 20 minutes in the air atmosphere. After that, the structure was subjected to a ultrasonic cleaning in pure water, and then dried.

Next, a resist paste prepared by dissolving a maleic resin in an organic solvent and dispersing therein a filler composed principally of talc and silica was applied in a prescribed pattern on the CdTe film 3 by screen printing. The resulting structure was then heat treated at 100°C for 10 minutes, to form a resist film 30 as shown in Figure 1(d).

Next, the structure was immersed for two minutes in a concentrated nitric acid solution to etch away the portions of the CdTe film 3 which were not covered with the resist film 30, as shown in Fig.1(e).

After that, the structure was cleaned with pure water for 10 minutes, immersed in a solution of 1 mole of potassium hydroxide to remove the resist film 30, again cleaned with pure water for 10 minutes, and then dried. In this way, the CdTe film divided into portions for respective cells was formed as shown in Fig.1(f).

Next, a carbon paste, to which a trace amount of copper was added, was applied on the divided CdTe films 3 by screen printing; then, the resulting structure was dried, and heated at 390°C for 30 minutes, thereby forming carbon films 4 as collector films while, at the same time, diffusing copper into the divided CdTe films 3. Further, a paste containing silver and indium was applied by screen printing over portions extending from the carbon films 4 to the CdS films 2 in the adjacent cells, and then dried to form a silver/indium film 5 to electrically connect each unit cell; further, silver/indium films 5 which would serve as the positive and negative terminals of the sub-module were formed in like manner on the cells at both ends, to complete the fabrication of a series-connected solar cell sub-module of the structure shown in Fig.1(g).

### COMPARATIVE EXAMPLE 1

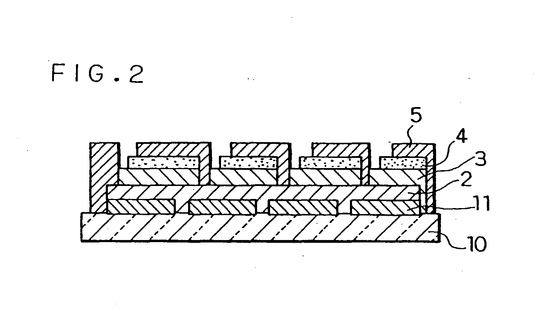

After forming the SnO₂ film 11 to a thickness of about 600 nm on the 35 cm by 35 cm glass substrate 10 (Corning #1737) shown in Fig.1(a) by using the same method as in EXAMPLE 1, laser scribing was performed with the same conditions as used in EXAMPLE 1, thereby forming individually separated transparent electrodes for 42 cells. Next, the CdS thin film 2 with a thickness of 70 nm was formed in the same manner as in EXAMPLE 1. Except that the CdTe film 3 was formed without dividing the CdS film 2, the same processing steps as employed in EXAMPLE 1 were repeated after the forming of the CdTe film 3, to complete the fabrication of a series-connected 42-cell solar cell of the structure shown in Fig.2.

### COMPARATIVE EXAMPLE 2

After forming the SnO₂ film 11 to a thickness of about 600 nm on the 35 cm by 35 cm glass substrate 10 (Corning #1737) shown in Fig.1(a) by using the same method as in EXAMPLE 1, laser scribing was performed with the same conditions as used in EXAMPLE 1, thereby forming individually separated transparent electrodes for 42 unit cells. Next, the CdS thin film 2 with a thickness of 70 nm was formed in the same manner as in EXAMPLE 1. Next, the structure was cleaned in running pure water using a nylon brush, and then dried. Except that the CdTe film 3 was formed without dividing the CdS film 2, the same processing steps as employed in EXAMPLE 1 were repeated after the forming of the CdTe film 3, to complete the fabrication of the series-connected solar cell sub-module of the structure shown in Fig.2.

Next, to verify the effect of the present invention, short circuit current density, open circuit voltage, and fill factor, a criterion for assessing the output characteristics, were measured on the solar batteries fabricated in EXAMPLE 1 and COMPARATIVE EXAMPLES 1 and 2, under the conditions of AM1.5 and 100 mW/cm². Further, the resistance between the positive and negative electrodes on adjacent cells was measured to evaluate the inter-cell resistance. The results are shown in Table 1.

**Table 1**

| | EXAMPLE 1 | COMPARATIVE EXAMPLE 1 | COMPARATIVE EXAMPLE 2 |
|---|---|---|---|
| SHORT CIRCUIT CURRENT DENSITY (mA/cm²) | 24.3 | 21.6 | 22.5 |
| OPEN CIRCUIT VOLTAGE *1 (V) | 33.6 | 21.7 | 28.1 |
| FILL FACTOR (%) | 65.4 | 35.7 | 56.2 |
| INTER-CELL RESISTANSE *2 (Ω) | 12 k | 0.5 k | 1 k |

| | | | |
|---|---|---|---|
| *1: Open circuit voltage of series-connected 42 unit cells | | | |
| *2: Maximum value of the inter-cell resistance between adjacent two unit cells | | | |

From the comparison of the characteristics between EXAMPLE 1 and COMPARATIVE EXAMPLES 1 and 2 shown in Table 1, it is apparent that a high performance solar cell can be fabricated in accordance with EXAMPLE 1 of the present invention. Presumably, in COMPARATIVE EXAMPLE 1, the inter-cell leakage, coupled with the pinholes formed in the CdS film by scribing debris, contributed to significant degradation in the performance, while in COMPARATIVE EXAMPLE 2, the inter-cell leakage contributed to the performance degradation. In EXAMPLE 1, on the other hand, the characteristics of excellent values were obtained presumably because these performance degrading factors were suppressed.

Although the present invention has been described in terms of the presently preferred embodiments, it is to be understood that such disclosure is not to be interpreted as limiting. Various alterations and modifications will no doubt become apparent to those skilled in the art to which the present invention pertains, after having read the above disclosure. Accordingly, it is intended that the appended claims be interpreted as covering all alterations and modifications as fall within the true spirit and scope of the invention.

## Claims

1. A method of fabricating a solar cell, comprising the steps of:
forming a transparent conductive film on a transparent insulating substrate;
forming a cadmium sulfide film on said transparent conductive film; and
dividing said transparent conductive film and said cadmium sulfide film into portions for respective unit cells by radiating a laser beam in a prescribed pattern onto said cadmium sulfide film and thereby removing simultaneously said cadmium sulfide film at portions thereof irradiated with said laser beam and said transparent conductive film at portions thereof lying below said irradiated portions.

2. The method in accordance with claim 1, wherein said step of forming a cadmium sulfide film on said transparent conductive film is performed by thermally decomposing an organic compound containing a cadmium-sulfur bond.

3. The method in accordance with claim 1, wherein said step of forming a cadmium sulfide film on said transparent conductive film comprises the steps of:
pulverizing an organic solvent solution of an organic compound containing a cadmium-sulfur bond into fine articles;
heating the obtained fine particles and thus vaporizing said organic solvent;
further heating said fine particles and bringing said organic compound into a gaseous body; and
thermally decomposing said gaseous organic compound by contacting said gaseous organic compound at the heated surface of said transparent insulating substrate.

4. The method in accordance with claim 1, wherein said step of forming a cadmium sulfide film on said transparent conductive film comprises the steps of:
applying an organic solvent solution of an organic compound containing a cadmium-sulfur bond to a source substrate so as to form an applied film;
disposing said applied film and said transparent conductive film adjacently so as to be parallel to and face each other;
heating said source substrate so as to evaporate said organic compound in said applied film; and
thermally decomposing said evaporated organic compound at the surface of said transparent conductive film heated to a temperature higher than that of said source substrate.

5. The method in accordance with claim 1, wherein said step of forming a cadmium sulfide film on said transparent conductive film comprises the steps of:
applying an organic solvent solution of an organic compound containing a cadmium-sulfur bond to said transparent conductive film so as to form an applied film;
heating said transparent insulating substrate; and
thermally decomposing said organic compound in said applied film.

6. A method of fabricating a solar cell, comprising the steps of:
forming a transparent conductive film on a transparent insulating substrate;
forming a cadmium sulfide film on said transparent conductive film;
dividing said transparent conductive film and said cadmium sulfide film into portions for respective unit cells;
forming a cadmium telluride film on said cadmium sulfide film;
dividing said cadmium telluride film into portions for respective unit cells;
forming a collector film on each of said divided cadmium telluride films;
electrically connecting said collector films and said divided cadmium sulfide films of adjacent unit cells; and
forming a positive terminal or a negative terminal on unit cells at both ends of a group of unit cells formed on said transparent insulating substrate;
wherein said step of dividing said transparent conductive film and said cadmium sulfide film into portions for respective unit cells is the step of radiating a laser beam in a prescribed pattern onto said cadmium sulfide film and removing simultaneously said cadmium sulfide film at portions thereof irradiated with said laser beam and said transparent conductive film at portions thereof lying below said irradiated portions.

7. The method in accordance with claim 6, wherein said step of forming a cadmium telluride film on said cadmium sulfide film comprises the steps of:
placing a source material containing a cadmium telluride as its main component on a source substrate;
disposing said source material and said cadmium sulfide film adjacently so as to be parallel to and face each other;
heating said source substrate and thus sublimating said source material; and
depositing a cadmium telluride film on said cadmium sulfide film heated to a temperature lower than that of said source substrate.
